# EUROPEAN PATENT SPECIFICATION

(11) **EP 2 824 698 B1**
(45) Date of publication and mention of the grant of the patent: **15.12.2021**
(21) Application number: 13757808.4
(22) Date of filing: 04.03.2013
(51) Int. Cl.: H01L 21/683, H01L 21/687

(54) **SUSCEPTOR**
SUSZEPTOR
SUSCEPTEUR

(30) Priority: 07.03.2012 JP 2012050029
(43) Date of publication of application: 14.01.2015
(73) Proprietor: Toyo Tanso Co., Ltd., Osaka-shi, Osaka 555-0011 (JP)
(72) Inventor: SASAKI, Seisyu, Kanonji-shi, Kagawa 769-1612 (JP)
(74) Representative: Glawe, Delfs, Moll
(86) International application number: PCT/JP2013/055820
(87) International publication number: WO 2013/133204

(56) References cited:
- WO-A1-2008/142115
- JP-A- S6 489 318
- JP-A- 2006 019 572
- JP-A- 2006 173 259
- JP-A- 2010 528 466
- US-A- 4 350 578
- US-A1- 2009 194 026
- US-A1- 2010 273 314
- US-A1- 2010 273 314

## Description

### TECHNICAL FIELD

The present invention relates to susceptors for use in manufacturing semiconductor devices and the like, and more particularly to a susceptor having a closest packed structure, i.e., in which the maximum number of recesses are disposed in a susceptor surface.

### BACKGROUND ART

Susceptors are used for growing a compound on a sapphire substrate in a manufacturing process of LED chips and for the Si epitaxial growth on a Si wafer in a manufacturing process of Si devices. The susceptors have recesses for placing various wafers. In many cases, the recess arrangement of such susceptors is such that the recesses are disposed in a concentric circular arrangement. However, such a concentric circular recess arrangement has large wasted space. For this reason, the number of the substrates that can be subjected to a coating process at one time is insufficient, so the process efficiency is poor.

In addition, when there is a great deal of vacant part in the surface of the susceptor main body, it acts as a resistant force against the gas flow blown onto the surface of the susceptor main body and consequently disturbs the gas flow. This can be a cause of inhibiting the uniform growth of thickness of various substrates, which results in degradation of the product quality and deterioration in the product yield.

In view of the problem, a honeycomb-shaped pattern arranged in a concentric hexagonal shape has been proposed (see the following Patent Literature 1). Such an arrangement is a closest packed arrangement, and it can minimize wasted space.

### CITATION LIST

### Patent Literature

[Patent Literature 1]
Published Japanese Translation of PCT application No. 2010-528466

A substrate holder with wafers arranged on concentric circles is disclosed in US 2010/0273314 A1.

### SUMMARY OF INVENTION

### TECHNICAL PROBLEM

However, the closest packed arrangement disclosed in the foregoing Patent Literature 1 is a hexagonal arrangement, so there is wasted space in an outer peripheral portion of the susceptor surface. The problem is that the closest packed arrangement is not obtained in the outer peripheral portion of the susceptor surface. In addition, the outer peripheral portion of the susceptor surface is a portion in which the maximum number of substrates can be placed. So, the presence of a great deal of wasteful space in this portion is undesirable because it may mean the risk that there are a large number of substrates that are considered as having poor quality.

The present invention has been accomplished in view of the foregoing circumstances. It is an object of the invention to provide a susceptor in which wasteful space is minimized and the maximum number of recesses are disposed in the outermost peripheral portion, by modifying an arrangement configuration of the recesses of the outermost peripheral recess array, which is disposed on the outer peripheral portion of a plurality of recess arrays that are disposed in a closest packed arrangement in a honeycomb-shaped pattern structure.

### SOLUTION TO PROBLEM

In order to accomplish the foregoing objects, the present invention provides a susceptor according to claim 1 wherein a multiplicity of circular recesses having an identical diameter are disposed in a circular surface thereof, and the multiplicity of recesses comprises a plurality of recess arrays disposed in a closest packed arrangement and an outermost peripheral recess array disposed on an outer peripheral portion of the plurality of recess arrays, characterized in that: the closest packed arrangement comprises one recess disposed at a central portion of the circular surface, and N number of concentric regular hexagonal recess arrays (N is any integer equal to or greater than 2) disposed on an outer peripheral side of the recess disposed at the central portion; in each of the recess arrays, each of the recesses forming the recess array is substantially in point contact with adjacent recesses thereto; each of the recesses forming a first recess array located to be an innermost one of the N number of the recess arrays is substantially in point contact with the recess disposed at the central portion; each of the recesses forming the E-th recess array being closer to the outer circumference than the first recess array of the plurality of recess arrays is substantially in point contact with each of the recesses forming the (E ― 1)th recess array being on the inner peripheral side of the E-th recess array, wherein E is any integer in the range 2 ≤ E ≤ N; and the outermost peripheral recess array is configured so that each of the recesses located at vertex positions of the N-th recess array of the N number of recess arrays forming the closest packed arrangement is substantially in point contact with two of the recesses forming the outermost peripheral recess array, that in the outermost peripheral recess array, each of the recesses forming the outermost peripheral recess array is substantially in point contact with adjacent recesses thereto, and that the same number of recesses as the number of the recesses disposed between two vertices of the N-th recess array are interposed between the two recesses related to one of adjacent vertex positions of the N-th recess array and the two recesses related to the other one of the adjacent vertex positions thereof.

Herein, the phrase "substantially in point contact" means that the recesses may be spaced apart to such a degree that they can be regarded as being in point contact with each other (for example, they may be spaced apart by only a few hundredths of a millimeter).

The phrase "between the two recesses related to one of adjacent vertex positions of the N-th recess array and the two recesses related to the other one of the adjacent vertex positions thereof" means "between the recess B and the recess C" and "between the recess D and the recess E" when the recesses B, C, D, and E are defined as follows. When the susceptor surface is viewed from the front, three vertex positions of the N-th recess array are defined as the left-side vertex position, the center vertex position, and the right-side vertex position. The left-side one of the two recesses of the outermost peripheral recess array that are substantially in point contact with the recess located at the left-side vertex position is denoted as a recess A, and the right-side one of the two recesses thereof is denoted as a recess B. The left-side one of the two recesses of the outermost peripheral recess array that are substantially in point contact with the recess located at the center vertex position is denoted as a recess C, and the right-side one of the two recesses thereof is denoted as a recess D. The left-side one of the two recesses of the outermost peripheral recess array that are substantially in point contact with the recess located at the right-side vertex position is denoted as a recess E, and the right-side one of the two recesses thereof is denoted as a recess F.

With the just-described configuration, wasteful space is minimized in the outermost peripheral portion, and it is made possible to provide a susceptor having a closest packed arrangement, in which the maximum number of recesses are disposed. Accordingly, by using a vapor deposition apparatus equipped with a susceptor having such a configuration, it is made possible to perform a layer growth process for a larger number of substrates at one process, so the efficiency of the process can be improved.

It should be noted that, in the present invention, the two recesses of the outermost peripheral recess array that are substantially in point contact with each of the recesses located at the vertex positions in the N-th recess array of the N number of recess arrays forming the closest packed arrangement may be substantially in point contact with each other, or may be away from each other.

In the present invention, it is preferable that the two recesses of the outermost peripheral recess array that are substantially in point contact with each of the recesses located at the vertex positions in the N-th recess array be substantially in point contact with each other, and that a line connecting the centers of the two recesses and an extension line of a line connecting a susceptor surface center portion with the center of the recess located at the vertex position in the N-th recess array and being substantially in point contact with the two recesses be orthogonal to each other. With such a configuration, the diameter of the susceptor can be made smallest among the susceptors provided with the same number of recesses. Therefore, it becomes possible to obtain the most efficient arrangement configuration with a small vacant area.

### ADVANTAGEOUS EFFECTS OF INVENTION

The present invention makes it possible to provide a susceptor with a closest packed arrangement, in which wasteful space is minimized and the maximum number of recesses are disposed in the outermost peripheral portion. Accordingly, by using a vapor deposition apparatus equipped with a susceptor having such a configuration, it is made possible to process a larger number of substrates at one process, so the efficiency of the process can be improved.

### BRIEF DESCRIPTION OF DRAWINGS

[Fig. 1] Fig. 1 is a plan view of a susceptor according to the present invention.
[Fig. 2] Fig. 2 is a partially-enlarged plan view of the susceptor according to the present invention.
[Fig. 3] Fig. 3 is a cross-sectional view taken along line X-X in Fig. 2.
[Fig. 4] Fig. 4 is a view for illustrating a recess arrangement configuration of an outermost peripheral recess array.
[Fig. 5] Fig. 5 is a view for showing that an outermost peripheral recess array A3 forms a concentric circular arrangement with regular hexagonal recess arrays A1 and A2, which is not encompassed by the claimed invention.
[Fig. 6] Fig. 6 is a view illustrating a susceptor in which the concentric regular hexagonal recess array A1 and an outermost peripheral recess array A2 are disposed.
[Fig. 7] Fig. 7 is a view illustrating a susceptor in which the concentric regular hexagonal recess arrays A1 to A3 and an outermost peripheral recess array A4 are disposed.
[Fig. 8] Fig. 8 is a view illustrating a susceptor in which the concentric regular hexagonal recess arrays A1 to A4 and an outermost peripheral recess array A5 are disposed.
[Fig. 9] Fig. 9 is a view illustrating a recess arrangement configuration of an outermost peripheral recess array A4 in the case where two recesses M(4), M(4) in the outermost peripheral recess array A4 are detached from each other.

### DESCRIPTION OF EMBODIMENTS

Hereinbelow, the present invention will be described based on the preferred embodiments. Note that the present invention is defined by the claims.

### (Embodiment 1)

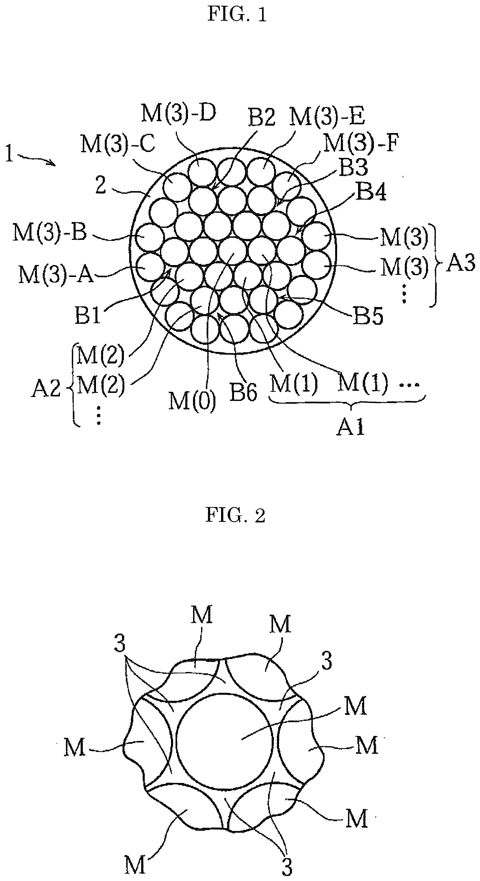

A vapor deposition apparatus used for manufacturing epitaxial wafers is, for example, a vertical type vapor deposition apparatus called a mini-batch furnace, which is capable of epitaxially growing a plurality of semiconductor wafers at the same time. This vertical type vapor deposition apparatus comprises a box-shaped chamber, a susceptor on which a plurality of waters can be placed substantially horizontally, a source gas supplying means for supplying a source gas into the chamber, a carrier gas supplying means for supplying a carrier gas into the chamber, and a heating means for heating the inside of the chamber. A susceptor according to the present invention, which is to be placed in this apparatus, is shown in Fig. 1.

Fig. 1 is a plan view of a susceptor according to the present invention. A susceptor 1 has a circular disk shape. A multiplicity of recesses M having an identical diameter are disposed regularly in a circular surface 2 of this susceptor 1. More specifically, the recesses comprise a plurality of recess arrays disposed in a closest packed arrangement, and an outermost peripheral recess array disposed on an outer peripheral portion of the plurality of recess arrays.

As illustrated in Fig. 1, the plurality of recess arrays disposed in a closest packed arrangement is constructed to have what is called a honeycomb-shaped pattern. That is, one recess M(0) is disposed at a central portion of a susceptor main body 2 (when the recess at the central portion needs to be indicated individually, it is represented by reference sign M(0)), and N number (2 in the present embodiment) of concentric regular hexagonal recess arrays A1 and A2 are disposed on the outer peripheral side of the recess M(0) located at the central portion. Each of recesses M(1) (when each of the recesses forming the recess array A2 needs to be indicated individually, it is represented by reference sign M(1)) forming the recess array A1 is substantially in point contact with adjacent recesses M(1) thereto. The other recess array A2 has the same configuration as that of the recess array A1. Each of recesses M(2) forming the recess array A2 (when each of the recesses forming the recess array A2 needs to be indicated individually, it is represented by reference sign M(2)) is substantially in point contact with adjacent recesses M(2) thereto.

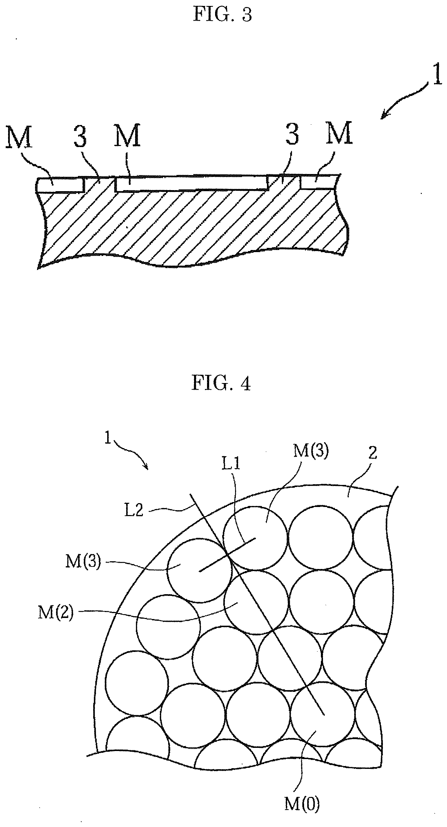

Herein, the phrase "substantially in point contact" means that, as illustrated in Figs. 2 and 3, the recesses are separated by a separating portion 3 to such a degree that they can be regarded as being in point contact with each other (for example, they may be spaced apart by only a few hundredths of a millimeter).

Each of the recesses M(1) forming the first recess array A1, which is located to be the innermost one of the recess arrays A1 and A2, is substantially in point contact with the recess M(0), which is located at the central portion. Moreover, each of the recesses M(2) forming the second recess array A2 is substantially in point contact with the respective recesses M(1) forming the first recess array A1. Concerning the case where N number (N is any integer equal to or greater than 2) of concentric regular hexagonal recess arrays A1 to An are provided, each of the recesses forming the E-th recess array (where E is any integer in the range 2 ≤ E ≤ N) being closer to the outer circumference than the first recess array is substantially in point contact with each of the recesses forming the (E ― 1)th recess array being on the inner peripheral side of the E-th recess array.

The recess arrays A1 and A2 are in a concentric regular hexagonal shape having the center point of the susceptor surface 2 as their centers. This means that in both of the recess arrays A1 and A2, recesses M are disposed at the vertex positions of the regular hexagon. Moreover, they are in a concentric regular hexagonal shape such that the number of recesses forming one side of the recess array A is greater by 1 than the number of recesses forming one side of the recess array that is one array inward therefrom; for example, the number of recesses of one side of the recess array A1 is 2, and the number of recesses of one side of the recess array A2 is 3.

With the above-described configuration, the arrangement configuration of the recesses is constructed by a honeycomb-shaped pattern, and it is such a structure that the recesses are disposed in a closest packed arrangement, in the region extending from the central portion of the susceptor surface 2 to the recess array A2.

### (Arrangement Configuration of Outermost Peripheral Recess Array)

An outermost peripheral recess array A3 has the following arrangement configuration. That is, as illustrated in Fig. 1, each of the recesses M(2) located at the vertices of the recess array A2 is substantially in point contact with two recesses M(3), M(3) forming the outermost peripheral recess array A3. These two recesses M(3), M(3) are substantially in point contact with each other. Moreover, as illustrated in Fig. 4, a line L1 connecting the centers of the two recesses M(3), M(3) and an extension line L2 of a line that connects the center point of the susceptor surface 2 with the center of the recess M(2) that is located at a vertex of the recess array A2 and is substantially in point contact with the two recesses M(3), M(3) are orthogonal to each other.

Here, description is made focusing on a vertex B2, among vertices B1 to B6 of the recess array A2. The description is made concerning the three vertices, the left-side vertex B1 to the left of the vertex B2, the right-side vertex B3 to the left of the vertex B2. The left-side one of the two recesses M(3) of the outermost peripheral recess array A3 that are substantially in point contact with the recess M(2) located at the left-side vertex B1 is denoted as a recess M(3)-A, and the right-side one thereof is denoted as a recess M(3)-B. The left-side one of the two recesses M(3) of the outermost peripheral recess array A3 that are substantially in point contact with the recess M(2) located at the central vertex B2 is denoted as a recess M(3)-C, and the right-side one thereof is denoted as a recess M(3)-D. The left-side one of the two recesses M(3) of the outermost peripheral recess array A3 that are substantially in point contact with the recess M(2) located at the right-side vertex B3 is denoted as a recess M(3)-E, and the right-side one thereof is denoted as a recess M(3)-F. In this case, the same number of recesses as the number (1 in the present embodiment) of the recesses disposed between the vertex B2 and the vertex B1 of the recess array A2 is disposed between the recess M(3)-C and the recess M(3)-B, and the same number of recesses as the number (1 in the present embodiment) of the recesses disposed between the vertex B2 and the vertex B3 of the recess array A2 is disposed between the recess M(3)-D and the recess M(3)-E. The arrangement configuration is such that the recess M(3)-B, the recess M(3) interposed between the recess M(3)-B and the recess M(3)-C, and the recess M(3)-C are substantially in point contact with adjacent recesses thereto, and the arrangement configuration is such that the recess M(3)-D and the recess M(3) interposed between the recess M(3)-D and the recess M(3)-E are substantially in point contact with adjacent recesses thereto.

Note that in the foregoing example, the description is made focusing on the vertex B2. However, concerning the other vertices B1 and B2 to B6 as well, the same number of recesses as the number (1 in the present embodiment) of the recesses disposed between the respective vertices of the recess array A2 is disposed between the two recesses M(3) of the outermost peripheral recess array A3 that are related to the respective vertex and the two recesses M(3) of the outermost peripheral recess array A3 that are related to the adjacent vertex thereto.

With the arrangement configuration of the outermost peripheral recess array as described above, it is made possible to obtain a susceptor having a closest packed arrangement, in which the maximum number of recesses are disposed. Accordingly, by using a vapor deposition apparatus equipped with a susceptor having such a configuration, a greater number of substrates can be processed at one time, and the efficiency of the process can be improved.

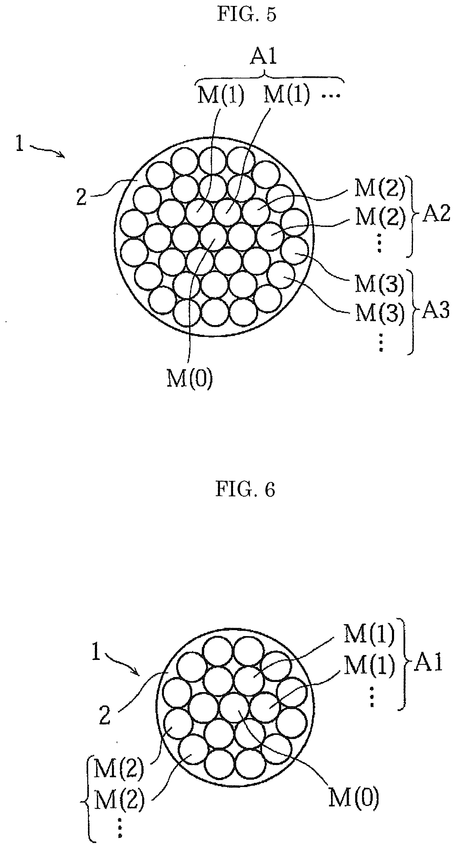

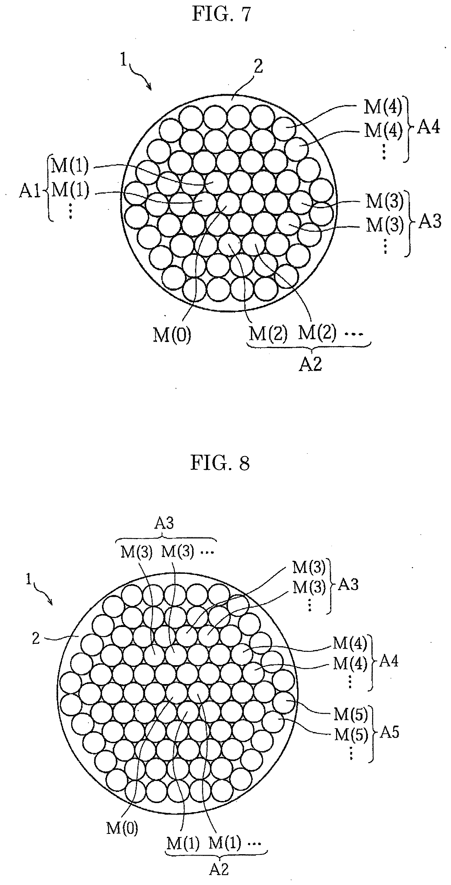

The foregoing embodiment has shown the susceptor having a structure such that the concentric regular hexagonal recess arrays A1 and A2 and the outermost peripheral recess array A3 are disposed. However, the present invention is not limited thereto, and the arrangement configuration illustrated in the foregoing embodiment can be widely applied to the susceptors in which concentric regular hexagonal recess arrays A1 to An and the outermost peripheral recess array An+1 are disposed. Fig. 6 shows a susceptor in which a concentric regular hexagonal recess array A1 and an outermost peripheral recess array A2 are disposed. Fig. 7 shows a susceptor in which concentric regular hexagonal recess arrays A1 to A3 and an outermost peripheral recess array A4 are disposed. Fig. 8 shows concentric regular hexagonal recess arrays A1 to A4 and an outermost peripheral recess array A5 are disposed. In all of Figs. 6 through 8, a susceptor having a closest packed arrangement, in which the maximum number of recesses are disposed, is achieved.

### (Other Embodiments)

In the foregoing embodiment, the two recesses M(3), M(3) of the outermost peripheral recess array A3 that are substantially in point contact with each of the recesses located at the vertex positions in the recess array A2 are substantially in point contact with each other. However, it is possible that the recess M(3) and the recess M(3) may be in such an arrangement configuration that they are detached from each other.

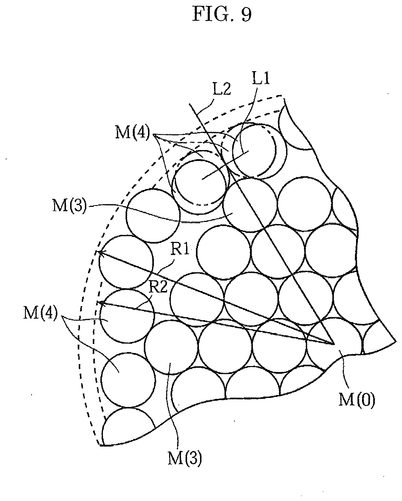

The following description is given with reference to Fig. 9. Here, Fig. 9 is a view illustrating an enlarged portion of a susceptor comprising recess arrays A1 to A3 constructed by a honeycomb-shaped pattern and an outermost peripheral recess array A4. In Fig. 9, two recesses M(4), M(4) in the outermost peripheral recess array A4 are in such an arrangement configuration that they are detached from each other. The recesses interposed between the recess M(4) and the recess M(4) in this case are not disposed linearly or in an arc shape, but are in such an arrangement configuration that some of the recesses protrude slightly outwardly. However, even with such an arrangement configuration, it is possible to dispose the maximum number of recesses at the outermost periphery, and it is possible to provide a susceptor having a closest packed arrangement, in which vacant space is small on the whole.

Here, radius R1 is defined as the radius of the susceptor having an arrangement configuration such that the two recesses M(4), M(4) of the outermost peripheral recess array are spaced apart, and radius R2 is defined as the radius of the susceptor having an arrangement configuration such that two recesses M(4), M(4) are substantially in point contact with each other and a line L1 connecting the centers of the two recesses M(4), M(4) and an extension line L2 of a line that connects the center point of the susceptor surface 2 with the center point of the recess M(3) that is located at a vertex of the recess array A3 and is substantially in point contact with the two recesses M(4), M(4) are orthogonal to each other. Then, the radius R1 is slightly greater than the radius R2. Therefore, the arrangement configuration in which the two recesses M(4), M(4) of the outermost peripheral recess array are spaced apart has a larger vacant area than the arrangement configuration in which the two recesses M(4), M(4) are substantially in point contact with each other. In other words, the arrangement configuration in which the two recesses M(4), M(4) are substantially in point contact with each other can minimize the diameter of the susceptor and reduce the vacant area, so it is the most efficient arrangement configuration.

In addition, in the case of the arrangement configuration in which the two recesses M(4), M(4) are detached from each other, the recesses may be disposed so as to form line symmetry with the extension line L2 of the line connecting the center point of the susceptor surface 2 with the center point of the recess M(2) that is located at a vertex of the recess array A3 and is substantially in point contact with the two recesses M(4), M(4), or they may be disposed asymmetrically therewith, in other words, in such an arrangement configuration in which the gap between the left-side recess M(4) and the extension line L2 is different from the gap between the right-side recess M(4) and the extension line L2. In the case of such an arrangement configuration, the recesses interposed between the recess M(4) and the recess M(4) are not disposed linearly or in an arc shape, but some of the recesses protrude slightly outward. However, even with such an arrangement configuration, it is similarly possible to dispose the maximum number of recesses at the outermost periphery, and it is similarly possible to provide a susceptor having a closest packed arrangement, in which vacant space is small on the whole.

### INDUSTRIAL APPLICABILITY

The present invention can be applied to susceptors for vapor deposition, for example, which are used for manufacturing semiconductor devices and the like.

### REFERENCE SIGNS LIST

- 1 --: Susceptor
- 2 --: Susceptor surface
- 3 --: Separating portion
- A1 to A5 --: Recess array
- M --: Recess
- M(0) --: Recess located at the center
- M(1) --: Recesses that form recess array A1
- M(2) --: Recesses that form recess array A2
- M(3) --: Recesses that form recess array A3
- M(4) --: Recesses that form recess array A4
- M(5) --: Recesses that form recess array A5

## Claims

1. A susceptor (1) wherein a multiplicity of circular recesses (M) having an identical diameter are disposed in a circular surface (2) thereof, where
the multiplicity of recesses (M) comprises a plurality of recess arrays (A1, A2) disposed in a closest packed arrangement and an outermost peripheral recess array (A3) disposed on an outer peripheral portion of the plurality of recess arrays (A1, A2);
the closest packed arrangement comprises one recess (M(0)) disposed at a central portion of the circular surface (2), and N number of concentric regular hexagonal recess arrays (A1, A2) (N is any integer equal to or greater than 2) disposed on an outer peripheral side of the recess (M(0)) disposed at the central portion; in each of the recess arrays (A1, A2), each of the recesses (M(1), M(2)) forming the recess array (A1, A2) is substantially in point contact with adjacent recesses thereto; each of the recesses (M(1)) forming a first recess array (A1) located to be an innermost one of the N number of the recess arrays (A1, A2) is substantially in point contact with the recess (M(0)) disposed at the central portion; each of the recesses (M(2)) forming the E-th recess array (A2) being closer to the outer circumference than the first recess array (A1) of the plurality of recess arrays (A1, A2) is substantially in point contact with each of the recesses (M(1)) forming the (E ― 1)th recess array (A1) being on the inner peripheral side of the E-th recess array (A2), wherein E is any integer in the range 2 ≤ E ≤ N; and
the outermost peripheral recess array (A3) is configured so that
i) each of the recesses (M(2)) located at vertex positions of the N-th recess array (A2) of the N number of recess arrays (A1, A2) forming the closest packed arrangement is substantially in point contact with two of the recesses (M(3)) forming the outermost peripheral recess array (A3),
ii) that in the outermost peripheral recess array (A3), each of the recesses (M(3)) forming the outermost peripheral recess array (A3) is substantially in point contact with adjacent recesses thereto, and that
iii) the same number of recesses (M(3)) as the number of the recesses (M(2)) sandwiched by the two recesses (M(2)) disposed at two vertices of the N-th recess array (A2) are interposed between the two recesses (M(3)) related to one of adjacent vertex positions of the N-th recess array (A2) and the two recesses (M(3)) related to the other one of the adjacent vertex positions thereof.

2. The susceptor according to claim 1, wherein: the two recesses (M(3)) of the outermost peripheral recess array (A3) that are substantially in point contact with each of the recesses (M(2)) located at the vertex positions in the N-th recess array (A2) are substantially in point contact with each other; and a line connecting the centers of the two recesses (M(3)) and an extension line of a line connecting a susceptor surface (2) center portion with the center of the recess (M(2)) located at the vertex position in the N-th recess array (A2) and being substantially in point contact with the two recesses (M(3)) are orthogonal to each other.

## Patentansprüche

1. Suszeptor (1), in dessen kreisförmiger Oberfläche (2) eine Anzahl von kreisförmigen Ausnehmungen (M) mit gleichem Durchmesser angeordnet sind, wobei
die Anzahl von Ausnehmungen (M) eine Anzahl von Ausnehmungsanordnungen (A1, A2), die in einer dicht gepackten Anordnung angeordnet sind, und eine äußerste periphere Ausnehmungsanordnung (A3) umfasst, die an einem äußeren peripheren Abschnitt der Anzahl von Ausnehmungsanordnungen (A1, A2) angeordnet ist,
die am dichtesten gepackte Anordnung eine Ausnehmung (M(0)), die an einem zentralen Abschnitt der kreisförmigen Oberfläche (2) angeordnet ist, und eine Anzahl N von konzentrischen, regelmäßig sechseckigen Ausnehmungsanordnungen (A1, A2) (N ist eine beliebige ganze Zahl gleich oder größer als 2) umfasst, die an einer äußeren Umfangsseite der Ausnehmung (M(0)), die an dem zentralen Abschnitt angeordnet ist, angeordnet sind, wobei in jeder der Ausnehmungsanordnungen (A1, A2) jede der Ausnehmungen (M(1), M(2)), die die Ausnehmungsanordnung (A1, A2) bilden, im Wesentlichen in Punktkontakt mit benachbarten Ausnehmungen dazu steht, wobei jede der Ausnehmungen (M(1)), die eine erste Ausnehmungsanordnung (A1) bilden, die so angeordnet ist, dass sie eine innerste der Anzahl N der Ausnehmungsanordnungen (A1, A2) ist, im Wesentlichen in Punktkontakt mit der Ausnehmung (M(0)) steht, die an dem zentralen Abschnitt angeordnet ist, jede der Ausnehmungen (M(2)), die die E-te Ausnehmungsanordnung (A2) bilden, die näher am Außenumfang liegt als die erste Ausnehmungsanordnung (A1) der Anzahl von Ausnehmungsanordnungen (A1, A2), im Wesentlichen in Punktkontakt mit jeder der Ausnehmungen (M(1)) steht, die die (E-1)-te Ausnehmungsanordnung (A1) bilden, die sich auf der inneren Umfangsseite der E-ten Ausnehmungsanordnung (A2) befindet, wobei E eine beliebige ganze Zahl im Bereich 2 ≤ E ≤ N ist, und wobei
die äußerste periphere Ausnehmungsanordnung (A3) so konfiguriert ist, dass
i) jede der Ausnehmungen (M(2)), die sich an den Scheitelpositionen der N-ten Ausnehmungsanordnung (A2) der N Anzahl von Ausnehmungsanordnungen (A1, A2) befinden, die die am dichtesten gepackte Anordnung bilden, im Wesentlichen in Punktkontakt mit zwei der Ausnehmungen (M(3)) ist, die die äußerste periphere Ausnehmungsanordnung (A3) bilden,
ii) dass in der äußersten peripheren Ausnehmungsanordnung (A3) jede der Ausnehmungen (M(3)), die die äußerste periphere Ausnehmungsanordnung (A3) bilden, im Wesentlichen in Punktkontakt mit benachbarten Ausnehmungen dazu steht, und dass
iii) die gleiche Anzahl von Ausnehmungen (M(3)) wie die Anzahl der Ausnehmungen (M(2)), die von den zwei Ausnehmungen (M(2)), die an zwei Scheitelpunkten der N-ten Ausnehmungsanordnung (A2) angeordnet sind, zwischen den zwei Ausnehmungen (M(3)), die sich auf eine der benachbarten Scheitelpunktpositionen der N-ten Ausnehmungsanordnung (A2) beziehen, und den zwei Ausnehmungen (M(3)), die sich auf die andere der benachbarten Scheitelpunktpositionen davon beziehen, angeordnet sind.

2. Suszeptor nach Anspruch 1, wobei, die beiden Ausnehmungen (M(3)) der äußersten peripheren Ausnehmungsanordnung (A3), die sich im Wesentlichen in Punktkontakt mit jeder der Ausnehmungen (M(2)) befinden, die sich an den Scheitelpositionen in der N-ten Ausnehmungsanordnung (A2) befinden, im Wesentlichen in Punktkontakt miteinander stehen, und eine Linie, die die Mittelpunkte der beiden Ausnehmungen (M(3)) verbindet, und eine Verlängerungslinie einer Linie, die einen mittleren Abschnitt einer Suszeptoroberfläche (2) mit dem Mittelpunkt der Ausnehmung (M(2)) verbindet, die sich an der Scheitelposition in der N-ten Ausnehmungsanordnung (A2) befindet und im Wesentlichen in Punktkontakt mit den beiden Ausnehmungen (M(3)) steht, orthogonal zueinander sind.

## Revendications

1. Suscepteur (1), dans lequel une multiplicité d'évidements (M) circulaires ayant un diamètre identique sont disposés dans une surface circulaire (2) de celui-ci, où
la multiplicité d'évidements (M) comprend une pluralité d'ensembles d'évidements (A1, A2) disposés en un agencement chargé au maximum et un ensemble d'évidements périphérique le plus externe (A3) disposé sur une portion périphérique externe de la pluralité d'ensembles d'évidements (A1, A2) ;
l'agencement chargé au maximum comprend un évidement (M(0)) disposé au niveau d'une portion centrale de la surface circulaire (2), et un nombre N d'ensembles d'évidements hexagonaux réguliers concentriques (A1, A2) (N est tout nombre entier supérieur ou égal à 2) disposé sur un côté périphérique externe de l'évidement (M(0)) disposé au niveau de la portion centrale ; dans chacun des ensembles d'évidements (A1, A2), chacun des évidements (M(1), M(2)) formant l'ensemble d'évidements (A1, A2) est sensiblement en contact ponctuel avec des évidements adjacents à celui-ci ; chacun des évidements (M(1)) formant un premier ensemble d'évidements (A1) situé pour être un ensemble le plus interne du nombre N des ensembles d'évidements (A1, A2) est sensiblement en contact ponctuel avec l'évidement (M(0)) disposé au niveau de la portion centrale ; chacun des évidements (M(2)) formant le E^{ième} ensemble d'évidements (A2) qui est plus près de la circonférence externe que le premier ensemble d'évidements (A1) de la pluralité d'ensembles d'évidements (A1, A2) est sensiblement en contact ponctuel avec chacun des évidements (M(1)) formant le (E-1)^{ième} ensemble d'évidements (A1) qui est sur le côté périphérique interne du E^{ième} ensemble d'évidements (A2), dans lequel E est tout nombre entier dans la plage de 2 ≤ E ≤ N ; et
l'ensemble d'évidements périphérique le plus externe (A3) est configuré de sorte que
i) chacun des évidements (M(2)) situés à des positions de sommet du N^{ième} ensemble d'évidements (A2) du nombre N d'ensembles d'évidements (A1, A2) formant l'agencement chargé au maximum soit sensiblement en contact ponctuel avec deux des évidements (M(3)) formant l'ensemble d'évidements périphérique le plus externe (A3),
ii) que, dans l'ensemble d'évidements périphérique le plus externe (A3), chacun des évidements (M(3)) formant l'ensemble d'évidements périphériques le plus externe (A3) soit sensiblement en contact ponctuel avec des évidements adjacents à celui-ci, et que
iii) le même nombre d'évidements (M(3)) que le nombre des évidements (M(2)) enserrés par les deux évidements (M(2)) disposés au niveau de deux sommets du N^{ième} ensemble d'évidements (A2) soient interposés entre les deux évidements (M(3)) liés à l'une de positions de sommet adjacentes du N^{ième} ensemble d'évidements (A2) et les deux évidements (M(3)) liés à l'autre des positions de sommet adjacentes de celui-ci.

2. Suscepteur selon la revendication 1, dans lequel : les deux évidements (M(3)) de l'ensemble d'évidements périphérique le plus externe (A3) qui sont sensiblement en contact ponctuel avec chacun des évidements (M(2)) situés aux positions de sommet dans le N^{ième} ensemble d'évidements (A2) sont sensiblement en contact ponctuel l'un avec l'autre ; et une ligne reliant les centres des deux évidements (M(3)) et une ligne d'extension d'une ligne reliant une portion centrale de surface (2) de suscepteur au centre de l'évidement (M(2)) situé à la position de sommet dans le N^{ième} ensemble d'évidements (A2) et qui est sensiblement en contact ponctuel avec les deux évidements (M(3)) sont orthogonales l'une à l'autre.
